Europäisches Patentamt

European Patent Office

Office européen des brevets

(19)

(11) **EP 1 319 269 B1**

(12) **EUROPÄISCHE PATENTSCHRIFT**

(45) Veröffentlichungstag und Bekanntmachung des
Hinweises auf die Patenterteilung:
**02.11.2005 Patentblatt 2005/44**

(21) Anmeldenummer: **01980274.3**

(22) Anmeldetag: **24.08.2001**

(51) Int Cl.$^7$: **H03K 3/0231**, H03K 3/70

(86) Internationale Anmeldenummer:
**PCT/EP2001/009828**

(87) Internationale Veröffentlichungsnummer:
**WO 2002/025815 (28.03.2002 Gazette 2002/12)**

(54) **ELEKTRISCHE SCHALTUNG ZUR ERZEUGUNG EINES PERIODISCHEN SIGNALS**

ELECTRIC CIRCUIT FOR GENERATING A PERIODIC SIGNAL

CIRCUIT ELECTRIQUE POUR PRODUIRE UN SIGNAL PERIODIQUE

(84) Benannte Vertragsstaaten:
**AT BE CH CY DE DK ES FI FR GB GR IE IT LI LU
MC NL PT SE TR**

(30) Priorität: **19.09.2000 DE 10046325**

(43) Veröffentlichungstag der Anmeldung:
**18.06.2003 Patentblatt 2003/25**

(73) Patentinhaber: **Infineon Technologies AG
81669 München (DE)**

(72) Erfinder:
• **HÖLLINGER, Werner
A-9500 Villach (AT)**
• **DÖRPER, Lukas
A-9500 Villach (AT)**

(74) Vertreter: **Barth, Stephan Manuel
Reinhard-Skuhra-Weise & Partner GbR,
Patentanwälte
Friedrichstrasse 31
80801 München (DE)**

(56) Entgegenhaltungen:
**US-A- 5 627 488          US-A- 5 793 257**

EP 1 319 269 B1

**Beschreibung**

Die vorliegende Erfindung betrifft eine elektrische Schaltung zur Erzeugung eines periodischen Signals.

Aus der EP 0834992 A2 ist eine monolithische MOS Switched-Capacitor-Schaltung mit on-chip-Oszillator bekannt.

Aus der US-A-6,028,488 ist ein digital gesteuerter Oszillator mit kondensator-geschalteter Frequenzauswahl bekannt.

Die einfachste Methode zur Erzeugung eines periodischen Signals besteht in der Entdämpfung eines LC-Schwingkreises mit Hilfe eines Verstärkers. Die Frequenzkonstanz von LC-Oszillatoren reicht für viele Anwendungen nicht aus. Für hohe Frequenzen kann L und C integriert werden. Eine wesentlich bessere Frequenzkonstanz lässt sich mit Schwingquarzen erreichen. Allerdings ist bei solchen Quarzoszillatoren immer ein externes Bauelement notwendig.

Eine weitere Gruppe von Oszillatoren sind Relaxationsoszillatoren, welche durch Laden und Entladen einer (integrierten/externen) Kapazität ein periodisches Signal erzeugen. Dort hängt die Oszillatorfrequenz im wesentlichen ab von:

- versorgungsspannungs- und temperaturabhängiger Stromquelle/ -senke

- Schalter in Serie zu frequenzbestimmenden Widerständen;

- einem Komparator mit versorgungsspannungs- und temperaturabhängiger Hysterese;

- zwei Komparatoren, deren Eingangsstufen sich durch die unterschiedlichen Triggerschwellen unterscheiden und daher nicht aufeinander abgestimmt sind (Mismatch).

Daher ist es Aufgabe der vorliegenden Erfindung, eine elektrische Schaltung zu schaffen, welche die Erzeugung einer Oszillatorfrequenz ohne externes Bauelement ermöglicht, die weitgehend unabhängig von Versorgungsspannung, Temperatur und Mismatch ist.

Erfindungsgemäß wird diese Aufgabe durch die in Anspruch 1 angegebene elektrische Schaltung gelöst.

Die erfindungsgemäße elektrische Schaltung weist den Vorteil auf, dass keine externen frequenzbestimmenden Bauteile notwendig sind. Weiterhin gibt es nur eine einzige Entladeeinrichtung (z.B. Stromsenke), während übliche Schaltungen zusätzlich eine geschaltete Stromquelle benötigen. Der Einfluss üblicher Schalter kann durch die Anwendung der Switched Capacitor Technik weitgehend eliminiert werden. Es verbleibt lediglich ein Resteinfluss durch das Umladen von parasitären Kapazitäten, die ebenfalls frequenzbestimmend sind. Durch eine geeignete Wahl der Kapazität und der Schalter lässt sich dieser Einfluß minimieren.

Die der vorliegenden Erfindung zugrundeliegende Idee besteht allgemein darin, dass durch die Verwendung einer Entladeeinrichtung und eines Referenzgenerators in Verbindung mit der Switched Capacitor Technik eine stabile Oszillation erzeugbar ist.

In den Unteransprüchen finden sich vorteilhafte Weiterbildungen und Verbesserungen der in Anspruch 1 angegebenen elektrische Schaltung.

Gemäß einer bevorzugten Weiterbildung weist die Takterzeugungseinrichtung eine Komparatoreinrichtung, deren einer Eingang mit dem Signalknoten verbunden ist, deren anderer Eingang mit einem zweiten Referenzpotential verbunden ist und deren Ausgang ein Schaltimpulssignal mit der ersten Periodendauer ausgibt, auf.

Vorteilhafterweise ist nur ein einfacher Komparator notwendig im Gegensatz zu den erwähnten üblichen Schaltungen, die einen Komparator mit Hysterese oder zwei Komparatoren benötigen. Der Komparator detektiert nur die positive Triggerschwelle. Wird diese Schwelle erreicht, so wird die frequenzbestimmende Kapazität bezogen auf eine durch das erste Referenzpotential bestimmte Mittenspannung umgeladen. Das entspricht der negativen Triggerschwelle bekannter Schaltungen, wobei hier die Hysterese nur durch den Referenzgenerator vorgegeben ist. Verschiebt sich durch Änderung der Versorgungsspannung die positive Triggerschwelle, so verschiebt sich die negative Schwelle in die gleiche Richtung, und die frequenzbestimmende Hysterese bleibt unverändert.

Gemäß einer weiteren bevorzugten Weiterbildung weist die Takterzeugungseinrichtung eine Frequenzteilereinrichtung zum Empfangen des Schaltimpulssignals und zum Erzeugen eines entsprechenden zweiten Signals mit einer zweiten Periodendauer, welche doppelt so groß ist wie die erste Periodendauer, auf. Damit ist die Oszillationsfrequenz halb so groß wie die Frequenz des ersten Signals am Komparator.

Gemäß einer weiteren bevorzugten Weiterbildung weist die Takterzeugungseinrichtung einen Taktgenerator zum Empfangen des zweiten Signals und zum Erzeugen des ersten Schaltertakts, des zweiten Schaltertakts und des periodischen Signals mit der zweiten Periodendauer auf. Dieser Taktgenerator dient im wesentlichen zum Shaping der Ausgangssignale.

Gemäß einer weiteren bevorzugten Weiterbildung ist der Taktgenerator ein RS-Flip-Flop. Dies ist eine besonders einfache Art der Implementierung.

Gemäß einer weiteren bevorzugten Weiterbildung weist die Frequenzteilereinrichtung ein impulsflankengesteuertes Flip-Flop auf, das das Schaltimpulssignal an dem C-Eingang empfängt und das zweite Signal an seinem invertierten Q-Ausgang liefert, wobei eine. Rückkopplungsschleife zwischen dem invertierten Q-Ausgang und dem D-Eingang vorgesehen ist. So lässt sich ein kostengünstiger Frequenzteiler realisieren.

Gemäß einer weiteren bevorzugten Weiterbildung weist die Takterzeugungseinrichtung eine Startup-Logikgeneratoreinrichtung zum Vorgeben des ersten und zweiten Schaltertakts beim Hochstarten der Schaltung auf. Damit lässt sich ein definierter Anfangszustand bereitstellen.

Gemäß einer weiteren bevorzugten Weiterbildung ist eine Referenzgeneratoreinrichtung zum Erzeugen des ersten und zweiten Referenzpotentials aus einem ersten und zweiten Versorgungspotential vorgesehen. Diese kann z.B. einfache Kaskoden enthalten.

Gemäß einer weiteren bevorzugten Weiterbildung ist die Takterzeugungseinrichtung derart gestaltet, dass der erste Schaltertakt und das periodische Signal übereinstimmen. Selbstverständlich könnten aber auch der zweite Schaltertakt und das periodische Signal übereinstimmen

Gemäß einer weiteren bevorzugten Weiterbildung ist die Entladeeinrichtung eine Stromsenkeneinrichtung mit einem konstanten Strom.

Ein Ausführungsbeispiel der Erfindung ist in den Zeichnungen dargestellt und in der nachfolgenden Beschreibung näher erläutert.

Es zeigen:

Fig. 1          eine schematische Darstellung einer elektrischen Schaltung gemäß einer Ausführungsform der vorliegenden Erfindung;

Fig. 2a) bis h)   eine schematische Darstellung der Signalverläufe an verschiedenen Knoten der elektrischen Schaltung nach Fig. 1; und

Fig. 3          die Abhängigkeit der Oszillatorfrequenz fosc der Schaltung nach Fig. 1 von der Potentialdifferenz $\Delta V = VDD - VSS$ der Versorgungspotentiale.

In den Figuren bezeichnen gleiche Bezugszeichen gleiche oder funktionsgleiche Bestandteile.

Es bezeichnen STS eine Stromsenkeneinrichtung, STUP eine Startup-Logikgeneratoreinrichtung, Cpar parasitäre Kapazitäten, S1-S6 Schaltereinrichtungen, K1, K2 einen ersten bzw. zweiten Anschluss von einer frequenzbestimmenden Kapazität C, I den Strom in STS, Φ1, Φ2 einen ersten bzw. zweiten Schaltertakt, CLK ein periodisches Signal bzw. die Oszillatorfrequenz, Vm ein erstes Referenzpotential bzw. die Mittelspannung, Vtr ein zweites Referenzpotential bzw. die Amplituden-Trägerschwelle, K3 einen Signalknoten, V1, V2 Signale an K1 bzw. K2, Vc das Signal an K3, KOMP einen Komparator, +,- die Eingänge von KOMP, AK den Ausgang von KOMP, CP das Signal an AK bzw. CI, TH einen Frequenzteiler bzw. Flip-Flop, CI den C-Eingang von TH, DI den D-Eingang von TH, QA den invertierten Ausgang von TH, RK eine Rückkopplungsschleife, QN das Signal an QA bzw. an einem Taktgenerator CG, VDD, VSS ein erstes bzw. zweites Versorgungspotential, RG eine Referenzgeneratoreinrichtung, fosc die Oszillatorfrequenz und t die Zeit.

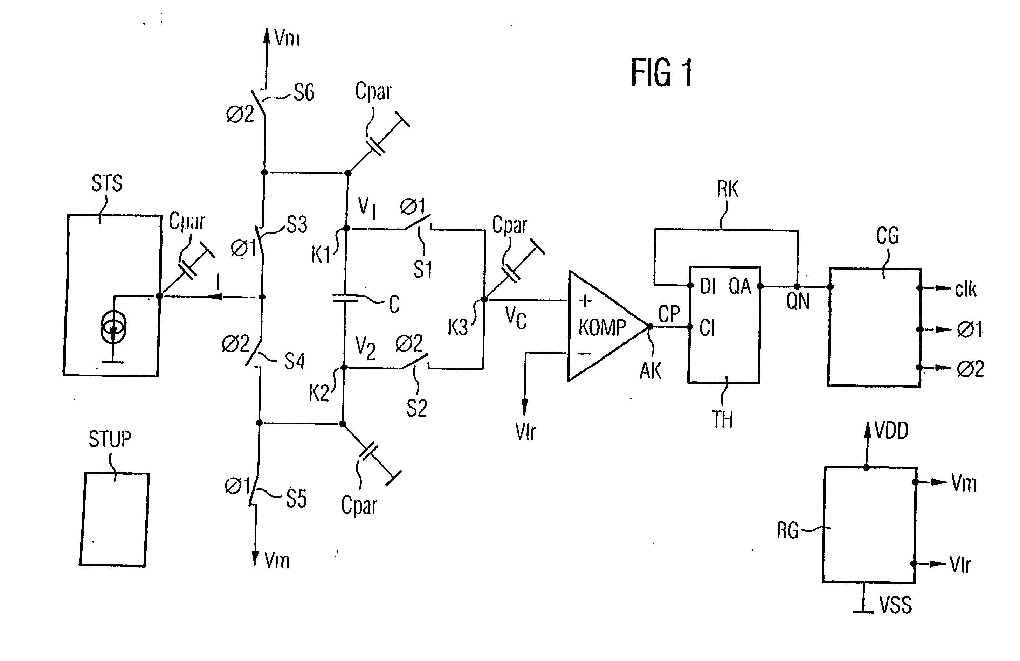

Fig. 1 zeigt eine schematische Darstellung einer elektrischen Schaltung gemäß einer Ausführungsform der vorliegenden Erfindung.

Die elektrische Schaltung gemäß dieser Ausführungsform ist ein freilaufender Oszillator und dient zur Erzeugung des periodischen Signals CLK mit einer Frequenz fosc von z.B. 350 kHz bei einem ersten Versorgungspotential von 1,6 V < VDD < 2,2 V und einem zweiten Versorgungspotential VSS von 0 V bzw. Masse. Das erste Referenzpotential bzw. die Mittelspannung Vm beträgt 0,8 V und das zweite Referenzpotential bzw. die Amplituden-Trägerschwelle Vtr beträgt 0,4 V. Die Oszillatorfrequenz fosc ist dabei unter Vernachlässigung der parasitären Kapazitäten gegeben durch

$$fosc = 1/T = I/(4 \cdot C' \cdot Vtr) \qquad (1)$$

Hierbei ist C' der Kapazitätswert von dem frequenzbestimmenden Kondensator C, T ist die fosc entsprechende Periodendauer, und I ist der Konstantstrom der Stromsenke STS.

Der Aufbau der Schaltung gemäß dieser Ausführungsform sieht folgendermaßen aus.

Der am Eingang + des Komparators KOMP anliegende Signalknoten K3 ist über die erste Schaltereinrichtung S1 mit dem ersten Anschluss K1 und über die zweite Schaltereinrichtung S2 mit dem zweiten Anschluss K2 verbunden. An dem Signalknoten K3 liegt ein erstes Signal Vc mit einer ersten Periodendauer T/2 an.

Die Stromsenkeneinrichtung STS ist über die dritte Schaltereinrichtung S3 mit dem ersten Anschluss K1 und über die vierte Schaltereinrichtung S4 mit dem zweiten Anschluss K2 verbunden und dient zum Entladen des frequenzbestimmenden Kondensators C. Die parasitären Kapazitäten Cpar an den gezeichneten Stellen sind dabei ebenfalls frequenzwirksam, da sie stets umgeladen werden müssen.

Der zweite Anschluss K2 ist über die fünfte Schaltereinrichtung S5 und der erste Anschluss K1 ist über die sechste Schaltereinrichtung S6 mit dem ersten Referenzpotential Vm verbunden.

Die Komparatoreinrichtung KOMP, die Startup-Logikgeneratoreinrichtung STUP, die Frequenzteilereinrichtung TH und der Taktgenerator CG bilden zusammen eine Takterzeugungseinrichtung zum Empfangen des ersten Signals Vc und zum Erzeugen des ersten Schaltertakts Φ1, des zweiten Schaltertakts Φ2 und des periodischen Signals CLK.

Die erste, dritte und fünfte Schaltereinrichtung S1, S3, S5 sind durch den ersten Schaltertakt Φ1 und die zweite, vierte und sechste Schaltereinrichtung S2, S4, S6 sind durch den zweiten Schaltertakt Φ2 ansteuerbar. Dabei sind der erste und zweite Schaltertakt Φ1, Φ2 nicht überlappend und invers zueinander.

Im in Fig. 1 gezeigten Zustand sind gerade die erste, dritte und fünfte Schaltereinrichtung S1, S3 und S5 geschlossen.

Die Takterzeugungseinrichtung umfasst die Komparatoreinrichtung KOMP, deren einer Eingang + mit dem Signalknoten K3 verbunden ist, deren anderer Eingang - mit einem zweiten Referenzpotential Vtr verbunden ist und deren Ausgang AK das Schaltimpulssignal CP mit der ersten Periodendauer T/2 entsprechend der Periodendauer T/2 des ersten Signals Vc ausgibt.

Die Takterzeugungseinrichtung umfasst weiterhin die Frequenzteilereinrichtung TH zum Empfangen des Schaltimpulssignals CP und zum Erzeugen des entsprechenden zweiten Signals QN mit der zweiten Periodendauer T, welche doppelt so groß ist wie die erste Periodendauer T/2. Die Frequenzteilereinrichtung TH ist bei diesem Beispiel ein impulsflankengesteuertes Flip-Flop, das das Schaltimpulssignal CP an dem C-Eingang CI empfängt und das zweite Signal QN an seinem invertierten Q-Ausgang QA liefert, wobei die Rückkopplungsschleife RK zwischen dem invertierten Q-Ausgang QA und dem D-Eingang DI vorgesehen ist.

Die Takterzeugungseinrichtung umfasst weiterhin den Taktgenerator CG zum Empfangen des zweiten Signals QN und zum Erzeugen des ersten Schaltertakts Φ1, des zweiten Schaltertakts Φ2 und des periodischen Signals CLK mit der zweiten Periodendauer T. Der Taktgenerator CG ist hier ein RS-Flip-Flop. Er dient zum Signalshaping, insbesondere sorgt er dafür, dass der erste und zweite Schaltertakt Φ1, Φ2 nicht überlappend und invers zueinander sind.

Die Takterzeugungseinrichtung umfasst schließlich die Startup-Logikgeneratoreinrichtung STUP zum Vorgeben des ersten und zweiten Schaltertakts Φ1, Φ2 beim Hochstarten der Schaltung, also zur Initialisierung.

Die Referenzgeneratoreinrichtung RG dient zum Erzeugen des ersten und zweiten Referenzpotentials Vm bzw. Vtr aus dem ersten und zweiten Versorgungspotential VDD bzw. VSS.

Im vorliegenden Fall ist die Takterzeugungseinrichtung derart gestaltet, dass der erste Schaltertakt Φ1 und das periodische Signal CLK übereinstimmen.

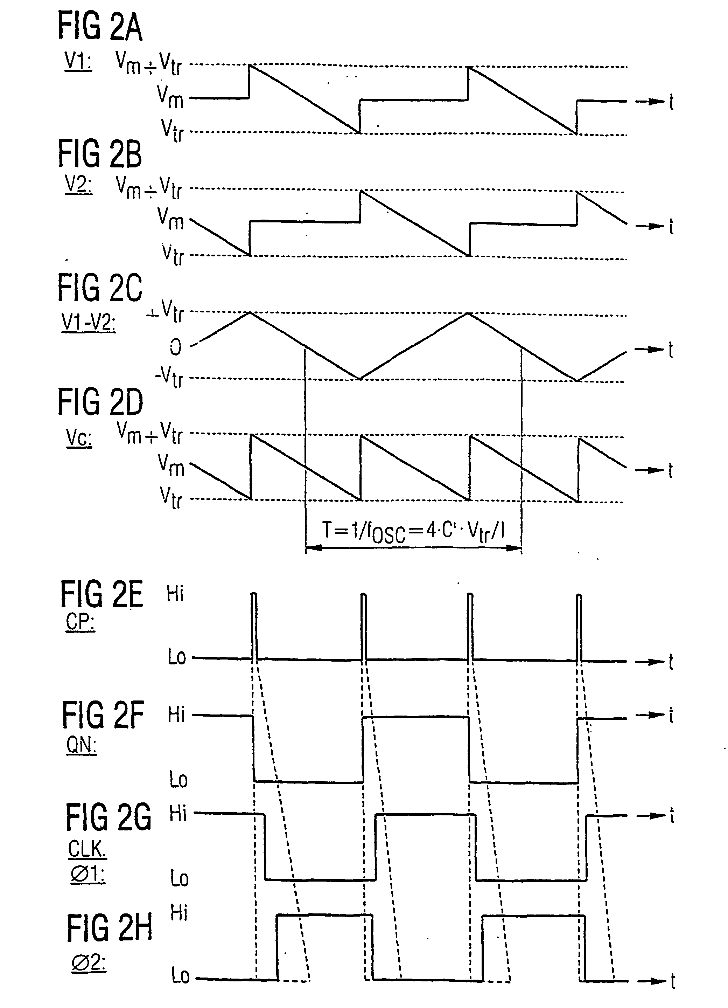

Fig. 2a) bis h) zeigen eine schematische Darstellung der Signalverläufe an verschiedenen Knoten der elektrischen Schaltung nach Fig. 1. Die Darstellung gibt den Idealfall unter Vernachlässigung der parasitären Kapazitäten Cpar wieder.

Fig. 2a) zeigt den zeitlichen Verlauf vom Signal V1 am Anschluss K1 der Kapazität C. Sind die Schalter S2, S4, S6 zunächst geschlossen und die Schalter S1, S3, S5 zunächst offen, so liegt das Signal V1 über den Schalter S6 auf dem ersten Referenzpotential Vm.

Fig. 2b) zeigt den zeitlichen Verlauf vom Signal V2 am Anschluss K2 der Kapazität C. Sind die Schalter S2, S4, S6 zunächst geschlossen und die Schalter S1, S3, S5 zunächst offen, so sinkt das Signal V2 auf das zweite Referenzpotential Vtr, da die Kapazität C über die Schalter S2, S4 in die Stromsenke STS entladen wird.

Fig. 2c) zeigt den zeitlichen Verlauf der Differenz V1 - V2 über der Kapazität C.

Erreicht das Signal V2 das zweite Referenzpotential Vtr, so liegt das Signal Vc am Signalknoten K3 und damit am Eingang + des Komparators KOMP über den Schalter S2. Gleichzeitig liegt aber am Eingang - des Komparators KOMP direkt das zweite Referenzpotential Vtr vom Referenzgenerator RG. Damit erzeugt der Komparator KOMP als Ausgangssignal CP am Ausgang AK eine positive Schaltflanke, wie in Fig. 2e) dargestellt.

Dies bewirkt wiederum einen Zustandswechsel des Signals QN am Ausgang QA des Frequenzteilers TH mit der steigenden Flanke des Signals CP und einen entsprechenden verzögerten Zustandswechsel des ersten und zweiten Schaltertakts Φ1 bzw. Φ2 und des periodischen Signal CLK am jeweiligen Ausgang des Taktgenerators CG, wie in Fig. 2f) bis h) dargestellt.

Die Verzögerung ist dabei derart, dass der erste und zweite Schaltertakt Φ1 bzw. Φ2 nicht überlappen, d.h. eine kurze Zeit lang alle Schalter S1-S6 offen sind. Dies lässt sich problemlos durch die inhärenten Eigenschaften des RS-FlipFlops des Taktgenerators CG erreichen. In Fig. 2g) und h) ist dies durch gestrichelte Zoomlinien veranschaulicht, welche den jeweiligen CP-Impuls aufzoomen.

Nunmehr wechselt also die Stellung der Schalter S1-S6 derart, dass die Schalter S2, S4, S6 offen und die Schalter S1, S3, S5 geschlossen sind.

Dies bewirkt, dass das Signal V1 auf Vm + Vtr springt, da das zweite Referenzpotential Vtr unmittelbar zuvor am Signalknoten K3 lag und aufgrund seiner hochohmigen Umgebung nicht abfließen kann. Gleichzeitig springt das Signal Vc am Signalknoten K3 auf Vm + Vtr, was bewirkt, dass das Signal CP am Ausgang AK des Komparators KOMP sofort wieder abfällt.

Im Anschluss daran sinkt das Signal V1 vom Wert Vm + Vtr auf das zweite Referenzpotential Vtr, da die Kapazität C über die Schalter S1, S3 in die Stromsenke STS entladen wird. Dabei liegt das Signal V2 über den Schalter S5 auf dem ersten Referenzpotential Vm.

Erreicht das Signal V1 das zweite Referenzpotential Vtr, so wird ein neuer Schaltimpuls des Signals CP am Ausgang AK des Komparators KOMP ausgelöst.

Dies bewirkt einen erneuten Zustandswechsel des Signals QN am Ausgang QA des Frequenzteilers TH mit der steigenden Flanke des Signals CP und einen entsprechenden verzögerten Zustandswechsel des ersten und zweiten Schaltertakts Φ1 bzw. Φ2 und des periodischen Signal CLK am jeweiligen Ausgang des Taktgenerators CG, wie in Fig. 2f) bis h) dargestellt. Deutlich erkennbar ist, dass der Frequenzteiler TH die Periodendauer von T/2 auf T verdoppelt, also der erste und zweite Schaltertakt Φ1 bzw. Φ2 und das periodische Signal CLK die Periodendauer T aufweisen.

Dieser erneute Zustandswechsel änderte die Stellung der Schalter S1-S6 derart, dass die Schalter S2, S4, S6 wieder geschlossen und die Schalter S1, S3, S5 wieder offen sind.

Diese Zustandswechsel der Schaltertakte Φ1 bzw. Φ2 setzen sich periodisch fort, wie in Fig. 2a) bis h) erkennbar.

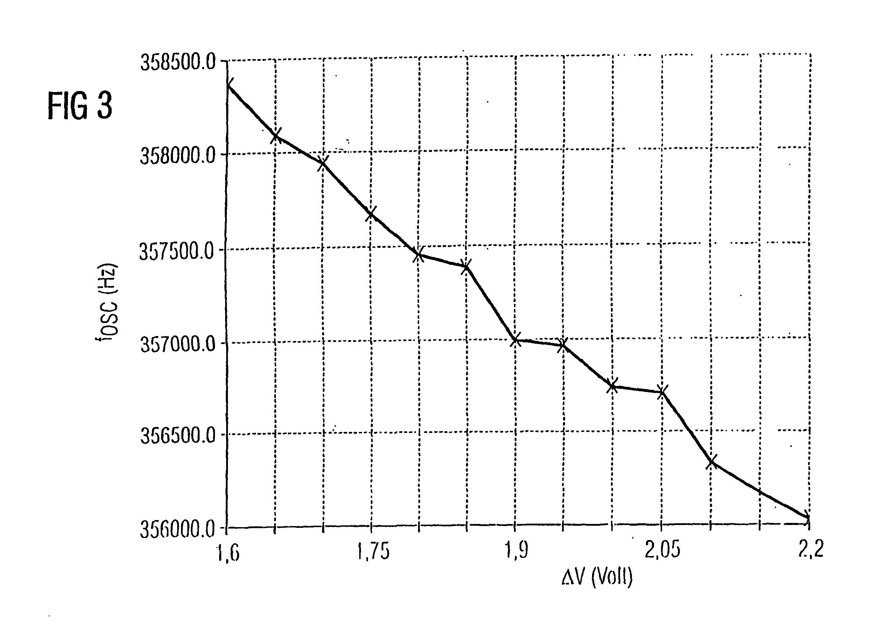

Fig. 3 zeigt die Abhängigkeit der Oszillatorfrequenz fosc der Schaltung nach Fig. 1 von der Potentialdifferenz ΔV = VDD - VSS der Versorgungspotentiale.

Deutlich erkennbar ist die Abhängigkeit marginal und beträgt lediglich 2500 Hz über dem betrachteten Potentialdifferenzintervall von 0,6 V.

Obwohl die vorliegende Erfindung vorstehend anhand eines bevorzugten Ausführungsbeispiels beschrieben wurde, ist sie darauf nicht beschränkt, sondern auf vielfältige Art und Weise modifizierbar.

Insbesondere sind die erwähnten Parameterbereiche für die Spannungen, Frequenzen und Bauteilgrößen nur beispielhaft und beliebig veränderbar.

Auch kann statt der Periodenverdoppelung durch entsprechende Teilung des Signals QN eine zweite Periodendauer im Taktgenerator eingestellt werden, die ein beliebiges geradzahliges Vielfaches der ersten Periodendauer ist.

Auch kann die Entladeeinrichtung statt der Stromsenke mit Konstantstrom I auch ein Widerstand R oder eine Stromquelle sein.

Bezugszeichenliste

| STS | Stromsenkeneinrichtung, Entladeeinrichtung |
| STUP | Startup-Logikgeneratoreinrichtung |
| Cpar | parasitäre Kapazität |
| S1-S6 | Schaltereinrichtungen |
| K1, K2 | erste, zweiter Anschluss von C |
| C | frequenzbestimmende Kapazität |
| I | Strom |
| Φ1, Φ2 | erster, zweiter Schaltertakt |
| CLK | periodisches Signal, Oszillatorfrequenz |
| Vm | erstes Referenzpotential, Mittelspannung |
| Vtr | zweites Referenzpotential, Amplituden-Trägerschwelle |
| K3 | Signalknoten |
| V1, V2 | Signal an K1, K2 |
| Vc | Signal an K3 |
| KOMP | Komparator |
| +,- | Eingänge von KOMP |
| AK | Ausgang von KOMP |
| CP | Signal an AK bzw. CI |
| TH | Frequenzteiler, Flip-Flop |
| CI | C-Eingang von TH |
| DI | D-Eingang von TH |
| QA | invertierter Ausgang von TH |
| RK | Rückkopplungsschleife |
| QN | Signal an QA bzw. an CG |
| VDD, VSS | erstes, zweites Versorgungspotential |
| RG | Referenzgeneratoreinrichtung |
| t | Zeit |
| fosc | Oszillatorfrequenz |

**Patentansprüche**

1. Elektrische Schaltung zur Erzeugung eines periodischen Signals (CLK) mit:

    einer Kondensatoreinrichtung (C), welche einen ersten Anschluss (K1) und einen zweiten Anschluss (K2) aufweist;

    einem Signalknoten (K3), der über eine erste Schaltereinrichtung (S1) mit dem ersten Anschluss (K1) und über eine zweite Schaltereinrichtung (S2) mit dem zweiten Anschluss (K2) verbunden ist, an dem ein erstes Signal (Vc) mit einer ersten Periodendauer (T/2) anliegt;

    einer Lade- und Entladeeinrichtung (STS), welche über eine dritte Schaltereinrichtung (S3) mit dem ersten Anschluss (K1) und über eine vierte Schaltereinrichtung (S4) mit dem zweiten Anschluss (K2) verbunden ist;

    wobei der zweite Anschluss (K2) über eine fünfte Schaltereinrichtung (S5) und der erste Anschluss (K1) über eine sechste Schaltereinrichtung (S6) mit einem ersten Referenzpotential (Vm) verbunden sind; und
    einer Takterzeugungseinrichtung (KOMP; STUP; TH; CG) zum Empfangen des ersten Signals (Vc) und zum Erzeugen eines ersten Schaltertakts (Φ1), eines zweiten Schaltertakts (Φ2) und des periodischen Signals (CLK);
    wobei
    der erste und zweite Schaltertakt (Φ1; Φ2) nicht überlappend und invers zueinander sind;
    die erste, dritte und fünfte Schaltereinrichtung (S1; S3; S5) durch den ersten Schaltertakt (Φ1) und die zweite, vierte
    und sechste Schaltereinrichtung (S2; S4; S6) durch den zweiten Schaltertakt (Φ2) ansteuerbar sind; und
    der erste und zweite Schaltertakt (Φ1; Φ2) und das periodische Signal (CLK) eine zweite Periodendauer (T) aufweisen, die ein geradzahliges Vielfaches der ersten Periodendauer (T/2) ist.

2. Elektrische Schaltung nach Anspruch 1,

**dadurch gekennzeichnet,**
**dass** die Takterzeugungseinrichtung (KOMP; STUP; TH; CG) aufweist:
eine Komparatoreinrichtung (KOMP), deren einer Eingang (+) mit dem Signalknoten (K3) verbunden ist, deren anderer Eingang (-) mit einem zweiten Referenzpotential (Vtr) verbunden ist und deren Ausgang (AK) ein Schaltimpulssignal (CP) mit der ersten Periodendauer (T/2) ausgibt.

3. Elektrische Schaltung nach Anspruch 2,
**dadurch gekennzeichnet,**
**dass** die Takterzeugungseinrichtung (KOMP; STUP; TH; CG) aufweist:

eine Frequenzteilereinrichtung (TH) zum Empfangen des Schaltimpulssignals (CP) und zum Erzeugen eines entsprechenden zweiten Signals (QN) mit einer zweiten Periodendauer (T), welche doppelt so groß ist wie die erste Periodendauer (T/2).

4. Elektrische Schaltung nach Anspruch 3,
**dadurch gekennzeichnet,**
**dass** die Takterzeugungseinrichtung (KOMP; STUP; TH; CG) aufweist:

einen Taktgenerator (CG) zum Empfangen des zweiten Signals (QN) und zum Erzeugen des ersten Schaltertakts (Φ1), des zweiten Schaltertakts (Φ2) und des periodischen Signals (CLK) mit der zweiten Periodendauer (T).

5. Elektrische Schaltung nach Anspruch 4,
**dadurch gekennzeichnet,**
**dass** der Taktgenerator (CG) ein RS-Flip-Flop ist.

6. Elektrische Schaltung nach Anspruch 3,
**dadurch gekennzeichnet,**
**dass** die Frequenzteilereinrichtung (TH) ein impulsflankengesteuertes Flip-Flop aufweist, das das Schaltimpulssignal (CP) an dem C-Eingang (CI) empfängt und das zweite Signal (QN) an seinem invertierten Q-Ausgang (QA) liefert, wobei eine Rückkopplungsschleife (RK) zwischen dem invertierten Q-Ausgang (QA) und dem D-Eingang (DI) vorgesehen ist.

7. Elektrische Schaltung nach einem der vorhergehenden Ansprüche,
**dadurch gekennzeichnet,**
**dass** die Takterzeugungseinrichtung (KOMP; STUP; TH; CG) aufweist:

eine Startup-Logikgeneratoreinrichtung (STUP) zum Vorgeben des ersten und zweiten Schaltertakts (Φ1; Φ2) beim Hochstarten der Schaltung.

8. Elektrische Schaltung nach einem der vorhergehenden Ansprüche,
**gekennzeichnet durch**
eine Referenzgeneratoreinrichtung (RG) zum Erzeugen des ersten und zweiten Referenzpotentials (Vm; Vtr) aus einem ersten und zweiten Versorgungspotential (VDD; VSS).

9. Elektrische Schaltung nach einem der vorhergehenden Ansprüche,
**dadurch gekennzeichnet,**
**dass** die Takterzeugungseinrichtung (KOMP; STUP; TH; CG) derart gestaltet ist, dass der erste Schaltertakt (Φ1) und das periodische Signal (CLK) übereinstimmen.

10. Elektrische Schaltung nach einem der vorhergehenden Ansprüche,
**dadurch gekennzeichnet,**
**dass** die Entladeeinrichtung eine Stromsenkeneinrichtung (STS) mit einem konstanten Strom (I) ist.

**Claims**

1. Electrical circuit for producing a cyclic signal (CLK) having:

a capacitor device (C) which has a first connection (K1) and a second connection (K2);
a signal node (K3) which is connected via a first switch device (S1) to the first connection (K1) and via a second switch device (S2) to the second connection (K2) and carries a first signal (Vc) having a first period duration (T/2);
a charging and discharging device (STS) which is connected via a third switch device (S3) to the first connection (K1) and via a fourth switch device (S4) to the second connection (K2);

where the second connection (K2) is connected to a first reference potential (Vm) via a fifth switch device (S5), and the first connection (K1) is connected to the first reference potential (Vm) via a sixth switch device (S6); and
a clock generation device (COMP; STUP; TH; CG) for receiving the first signal (Vc) and for generating a first switch clock (Φ1), a second switch clock (Φ2) and the cyclic signal (CLK);
where
the first and second switch clocks (Φ1; Φ2) do not overlap and are the inverse of one another;
the first, third and fifth switch devices (S1; S3; S5) can be actuated by the first switch clock (Φ1), and the second, fourth and sixth switch devices (S2; S4; S6) can be actuated by the second switch clock (Φ2); and

the first and second switch clocks (Φ1; Φ2) and the cyclic signal (CLK) have a second period duration (T), which is an even-numbered multiple of the first period duration (T/2).

2. Electrical circuit according to Claim 1,
   **characterized**
   **in that** the clock generation device (COMP; STUP; TH; CG) has:

   a comparator device (COMP), one input (+) of which is connected to the signal node (K3), the other input (-) of which is connected to a second reference potential (Vtr), and the output (AK) of which outputs a switching pulse signal (CP) having the first period duration (T/2).

3. Electrical circuit according to Claim 2,
   **characterized**
   **in that** the clock generation device (COMP; STUP; TH; CG) has:

   a frequency divider device (TH) for receiving the switching pulse signal (CP) and for generating a corresponding second signal (QN) having a second period duration (T), which is twice as long as the first period duration (T/2).

4. Electrical circuit according to Claim 3,
   **characterized**
   **in that** the clock generation device (COMP; STUP; TH; CG) has:

   a clock generator (CG) for receiving the second signal (QN) and for generating the first switch clock (Φ1), the second switch clock (Φ2) and the cyclic signal (CLK) with the second period duration (T).

5. Electrical circuit according to Claim 4,
   **characterized**
   **in that** the clock generator (CG) is an RS flipflop.

6. Electrical circuit according to Claim 3,
   **characterized**
   **in that** the frequency divider device (TH) has a pulse-edge-controlled flipflop which receives the switching pulse signal (CP) at the C input (CI) and delivers the second signal (QN) at its inverted Q output (QA), with a feedback loop (RK) being provided between the inverted Q output (QA) and the D input (DI).

7. Electrical circuit according to one of the preceding claims,
   **characterized**
   **in that** the clock generation device (COMP; STUP; TH; CG) has:

a startup logic generator device (STUP) for prescribing the first and second switch clocks (Φ1; Φ2) when the circuit is started up.

8. Electrical circuit according to one of the preceding claims,
   **characterized by**
   a reference generator device (RG) for generating the first and second reference potentials (Vm; Vtr) from a first and a second supply potential (VDD; VSS).

9. Electrical circuit according to one of the preceding claims,
   **characterized**
   **in that** the clock generation device (COMP; STUP; TH; CG) is in a form such that the first switch clock (Φ1) and the cyclic signal (CLK) match.

10. Electrical circuit according to one of the preceding claims,
    **characterized**
    **in that** the discharging device is a current sink device (STS) with a constant current (I).

**Revendications**

1. Circuit électrique pour produire un signal périodique (CLK) comprenant :

   un dispositif condensateur (C) qui comprend une première connexion (K1) et une deuxième connexion (K2) ;
   un noeud de signaux (K3) qui est relié avec la première connexion (K1) via un premier dispositif de commutation (S1), et avec la deuxième connexion (K2) via un deuxième dispositif de commutation (S2), un premier signal (Vc), ayant une première durée de période (T/2), étant appliqué au noeud de signaux (K3) ;
   un dispositif de chargement et de déchargement (STS) qui est relié avec la première connexion (K1) via un troisième dispositif de commutation (S3) et avec la deuxième connexion (K2) via un quatrième dispositif de commutation (S4) ;

   dans lequel la deuxième connexion (K2), via un cinquième dispositif de commutation (S5), et la première connexion (K1), via un sixième dispositif de commutation (S6), sont reliées avec un premier potentiel de référence (Vm) ; et
   un dispositif de génération d'horloge (KOMP ; STUP ; TH ; CG) pour recevoir le premier signal (Vc) et pour produire une première horloge de commutation (φ1), une deuxième horloge de commutation (φ2) et un signal périodique (CLK) ;

dans lequel
la première et la deuxième horloge de commutation (φ1 ; φ2) ne se chevauchent pas et sont l'inverse l'une de l'autre ;
le premier, le troisième et le cinquième dispositif de commutation ( S1 ; S3 ; S5) peuvent être actionnés par la première horloge de commutation (φ1) et le deuxième, le quatrième et le sixième dispositif de commutation ( S2 ; S4 ; S6) par la deuxième horloge de commutation (φ2) ; et
la première, la deuxième horloge de commutation (φ1 ; φ2) et le signal périodique (CLK) comprennent une deuxième durée de période (T) qui est un multiple pair de la première durée de période (T/2) ;

2. Circuit électrique selon la revendication 1, **caractérisé en ce que** le dispositif de génération d'horloge (KOMP ; STUP ; TH ; CG) comprend :

   un dispositif de comparaison (KOMP) dont une entrée (+) est reliée avec le noeud de signaux (K3), l'autre entrée (-) est reliée avec un deuxième potentiel de référence (Vtr) et la sortie (AK) délivre un signal de commutation (CP) avec la première durée de période (T/2).

3. Circuit électrique selon la revendication 2, **caractérisé en ce que** le dispositif de génération d'horloge (KOMP ; STUP ; TH ; CG) comprend :

   un dispositif diviseur de fréquence (TH) pour recevoir le signal de commutation (CP) et pour produire un deuxième signal correspondant (QN) ayant une deuxième durée de période (T) qui correspond au double de la première durée de période (T/2).

4. Circuit électrique selon la revendication 3, **caractérisé en ce que** le dispositif de génération d'horloge (KOMP ; STUP ; TH ; CG) comprend :

   un générateur d'horloge (CG) pour recevoir le deuxième signal (QN) et pour produire la première horloge de commutation (φ1), la deuxième horloge de commutation (φ2) et le signal périodique (CLK) avec la deuxième durée de période (T).

5. Circuit électrique selon la revendication 4, **caractérisé en ce que** le générateur d'horloge (CG) est un flip-flop RS.

6. Circuit électrique selon la revendication 3, **caractérisé en ce que** le dispositif diviseur de fréquence (TH) comprend un flip-flop, commandé par flanc d'impulsion, qui reçoit le signal de commutation (CP) à l'entrée C (CI) et fournit le deuxième signal (QN) à sa sortie Q inversée (QA), une boucle de rétroaction (RK) étant prévue entre la sortie Q inversée (QA) et l'entrée D (DI).

7. Circuit électrique selon l'une quelconque des revendications précédentes, **caractérisé en ce que** le dispositif de génération d'horloge (KOMP ; STUP ; TH ; CG) comprend :

   un dispositif de génération logique de démarrage (STUP) pour fixer la première et la deuxième horloge de commutation (φ1 ; φ2) lors du démarrage du circuit.

8. Circuit électrique selon l'une quelconque des revendications précédentes, **caractérisé par** un dispositif de génération de référence (RG) pour produire le premier et le deuxième potentiel de référence (Vm ; Vtr) à partir d'un premier et d'un deuxième potentiel d'alimentation (VDD ;VSS).

9. Circuit électrique selon l'une quelconque des revendications précédentes, **caractérisé en ce que** le dispositif de génération d'horloge (KOMP ; STUP ; TH ; CG) est réalisé de telle façon que la première horloge de commutation (φ1) et le signal périodique (CLK) correspondent l'un à l'autre.

10. Circuit électrique selon l'une quelconque des revendications précédentes, **caractérisé en ce que** le dispositif de déchargement est un dispositif récepteur de courant (STS) ayant un courant (I) constant.

FIG 1

EP 1 319 269 B1

# FIG 2A

V1: $V_m \div V_{tr}$ ---

$V_m$

$V_{tr}$

# FIG 2B

V2: $V_m \div V_{tr}$

$V_m$

$V_{tr}$

# FIG 2C

V1-V2: $\div V_{tr}$

0

$-V_{tr}$

# FIG 2D

Vc: $V_m \div V_{tr}$

$V_m$

$V_{tr}$

$T = 1/f_{OSC} = 4 \cdot C' \cdot V_{tr}/I$

# FIG 2E

CP:

Hi

Lo

# FIG 2F

QN:

Hi

Lo

# FIG 2G

CLK. Ø1:

Hi

Lo

# FIG 2H

Ø2:

Hi

Lo

10

# FIG 3

EP 1 319 269 B1